# EUROPEAN PATENT APPLICATION

(11) **EP 2 955 756 A1**
(43) Date of publication of application: **16.12.2015**
(21) Application number: 14197605.0
(22) Date of filing: 12.12.2014
(51) Int. Cl.: H01L 29/66, H01L 29/78

(54) **Semiconductor device with silicon carbide embedded dummy pattern**

(30) Priority: 11.06.2014 US 201414301348
(71) Applicant: MediaTek, Inc, Hsin-Chu 300 (TW)
(72) Inventor: Lee, Tung-Hsing, 247 New Taipei City (TW); Yang, Ming-Tzong, 308 Hsinchu County (TW); Huang, Wei-Che, 310 Hsinchu County (TW); Hung, Cheng-Chou, 303 Hsinchu County (TW)
(74) Representative: Hoefer & Partner Patentanwälte mbB

(57) **Abstract**

A semiconductor device with dummy patterns for alleviating micro-loading effect includes a semiconductor substrate having thereon a middle annular region between an inner region and an outer region; a SiC device on the semiconductor substrate within the inner region; and a plurality of dummy patterns provided on the semiconductor substrate within the middle annular region. At least one of the dummy patterns contains SiC.

## Description

### Background

The present invention relates generally to the field of semiconductor integrated circuits and, more particularly, to an improved semiconductor device with SiC-embedded dummy pattern that encircles the semiconductor device, which is capable of alleviating the micro-loading effect.

As known in the art, stress can be introduced in the channel region of a MOS transistor to increase carrier mobility, thereby enhancing the performance of the MOS transistor. Generally, it is desirable to induce tensile stress in the channel region of an NMOS device in a source-to-drain direction, and to induce compressive stress in the channel region of a PMOS device in a source-to-drain direction. To induce stress in the channel region of a MOS transistor, epitaxially grown stressors are formed in the source and drain regions of the MOS devices.

However, the conventional art suffers from the influence of micro-loading effect, which occurs due to a difference in pattern densities of the epitaxially grown stressors on a single die. The micro-loading effect leads to variation of epitaxial growth rates between a region of a higher density and a region of a lower density. Due to the difference in growth rates, the thickness of the resulting stressor film becomes non-uniform. In addition, the composition of the epitaxial stressor in an isolated active region usually differs from that in a densely packed active region. Such non-uniformities may alter the stress level of the epitaxial stressor and adversely affect device performance.

Accordingly, there is a strong need in this industry to provide an improved semiconductor device and method for alleviating the micro-loading effect, while at the same time overcoming the deficiencies of the prior art.

### Summary

It is one object of the present invention to provide an improved SiC device with specially designed SiC-embedded dummy pattern that encompasses the SiC device, which is capable of alleviating the micro-loading effect during the epitaxial growth of SiC.

According to the claimed invention, a semiconductor device with dummy patterns for alleviating micro-loading effect comprises a semiconductor substrate having thereon a middle annular region between an inner region and an outer region; a SiC device on the semiconductor substrate within the inner region; and a plurality of first dummy patterns provided on the semiconductor substrate within the middle annular region. At least one of the first dummy patterns contains SiC.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention, and are incorporated in and constitute a part of this specification. The drawings illustrate embodiments of the invention and, together with the description, serve to explain the principles of the invention. In the drawings:
FIG. 1 is a schematic top view showing the layout of the SiC device and SiC dummy pattern in accordance with the first preferred embodiment of this invention;
FIG. 2 is a schematic top view showing the layout of the SiC device and SiC-embedded dummy pattern in accordance with the second preferred embodiment of this invention;
FIG. 3 is a schematic, cross-sectional view taken along line I-I of FIG. 2;
FIG. 4 is a schematic top view showing the layout of the SiC device and SiC-embedded dummy pattern in accordance with the third preferred embodiment of this invention;
FIG. 5 is a cross-sectional view taken along line II-II of FIG. 4; and
FIG. 6 is a schematic top view showing the layout of the SiC device and SiC-embedded dummy pattern in accordance with the fourth preferred embodiment of this invention.

### Detailed Description

This invention pertains to an improved SiC device with SiC-embedded dummy patterns encompassing the SiC device, which is capable of alleviating or counteracting the micro-loading effect during the epitaxial growth of SiC. The SiC device may function as a circuit component of mixed-signal circuits, RF circuits or analog circuits

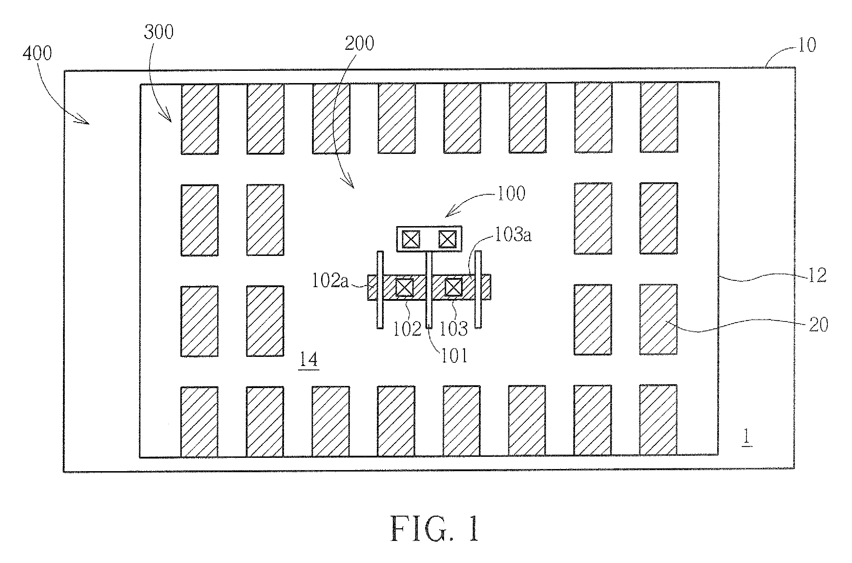

FIG. 1 is a schematic top view showing the layout of the SiC device and SiC dummy pattern in accordance with the first preferred embodiment of this invention. As shown in FIG. 1, a SiC device 100 is formed in an isolated region 10 of a substrate 1. The substrate 1 may be a silicon substrate, silicon-on-insulator (SOI) substrate or other suitable semiconductor substrates. The SiC device 100 may include but not limited to N-channel metal-oxide-semiconductor (NMOS) transistors or bipolar junction transistors. By way of example, the SiC device 100 is an NMOS transistor and comprises a gate stack 101, an N⁺ source diffusion region 102 and an N⁺ drain diffusion region 103.

A P well 12 is formed in the isolated region 10 of a substrate 1, wherein the SiC device 100 is fabricated within the P well 12. Both of the N⁺ source diffusion region 102 and the N⁺ drain diffusion region 103 contain an epitaxially grown SiC stressor layer. Shallow trench isolation (STI) 14 is formed in the substrate 1 to electrically isolate the SiC device 100.

Typically, the steps before growing the SiC stressor layer in the source and drain regions include forming a gate stack on a semiconductor substrate, forming spacers on sidewalls of the gate stack, and forming recesses in the silicon substrate along gate spacers. Then the SiC stressor layer may be epitaxially grown in the recesses and annealed. The SiC stressor layer may be formed by any suitable methods known in the art, for example, selective epitaxial growth (SEG) methods.

To effectively counteract the micro-loading effect of SiC growth, a plurality of SiC dummy patterns 20 are added to a middle annular region 300. The middle annular region 300 is between an inner region 200 and an outer region 400, wherein the SiC device 100 is disposed within the inner region 200. The SiC dummy patterns 20 surround the SiC device 100. The SiC dummy patterns 20 are active areas, which are defined concurrently with the active area or oxide define (OD) region of the SiC device 100. SiC is grown in these active areas concurrently with the SiC stressor layer grown in the n⁺ source diffusion region 102 and the n⁺ drain diffusion region 103 of the SiC device 100.

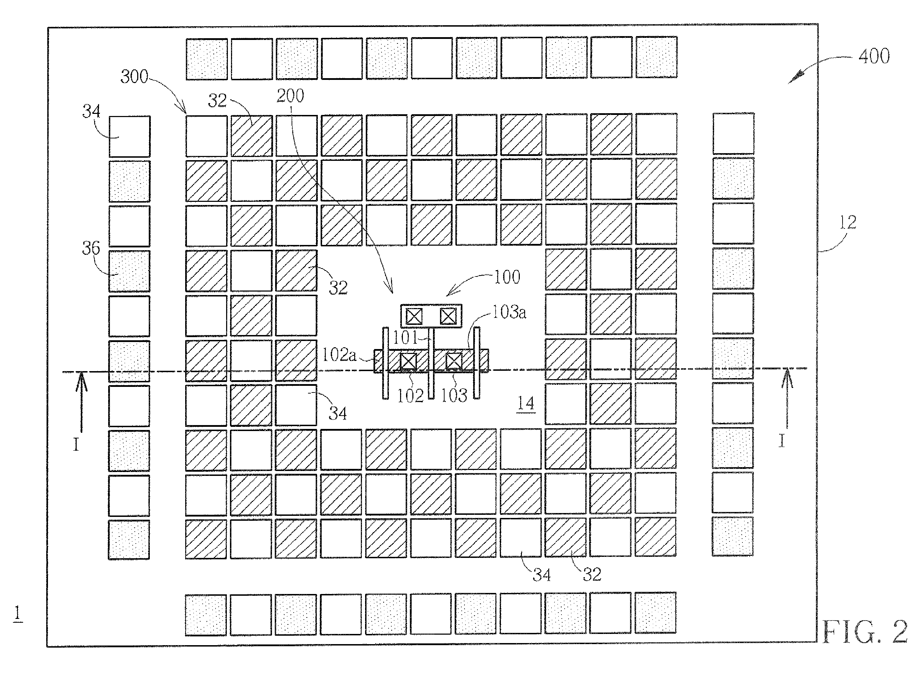

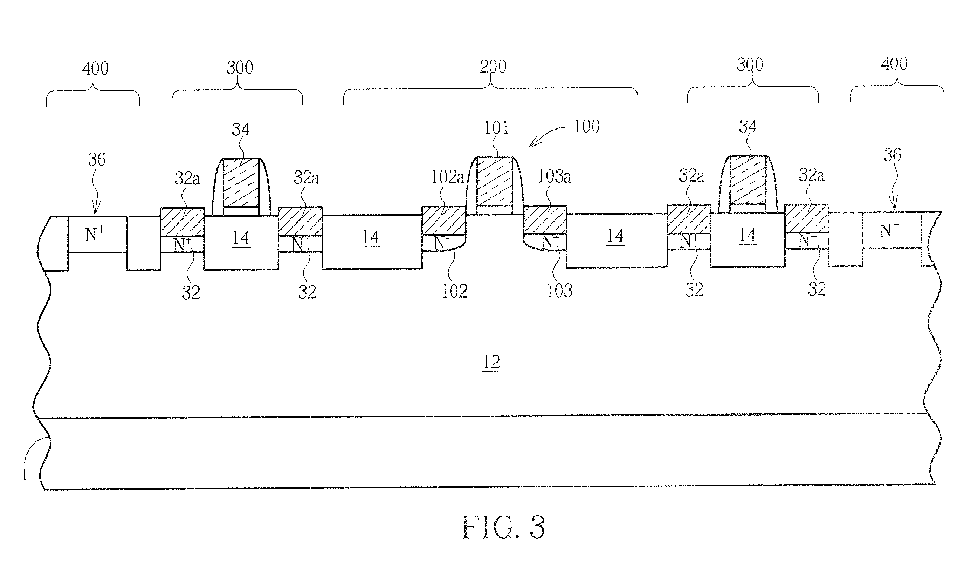

Please refer to FIG. 2 and FIG. 3. FIG. 2 is a schematic top view showing the layout of the SiC device and SiC-embedded dummy pattern in accordance with the second preferred embodiment of this invention, and FIG. 3 is a schematic, cross-sectional diagram taken along line I-I of FIG. 2, wherein like numeral numbers designate like regions, elements or layers.

As shown in FIG. 2 and FIG. 3, likewise, a SiC device 100 is formed in an N well 12 of a substrate 1. The substrate 1 may be a silicon substrate, SOI substrate or other suitable semiconductor substrates. According to the second preferred embodiment, the SiC device 100 may include but not limited to an NMOS transistor and comprises a gate stack 101, an N⁺ source diffusion region 102 and an N⁺ drain diffusion region 103. A SiC stressor layer 102a is formed on the N⁺ source diffusion region 102 and a SiC stressor layer 103a is formed on the N⁺ drain diffusion region 103. STI 14 is formed in the substrate 1 to electrically isolate the SiC device 100.

In this embodiment, a plurality of SiC-embedded dummy diffusion regions 32 and a plurality of dummy poly-Si patterns 34 are provided around the SiC device 100. As best seen in FIG. 2, the SiC-embedded dummy diffusion regions 32 and the dummy poly-Si patterns 34, which together encompass the SiC device 100, are arranged in an alternate manner, which is similar to a chessboard pattern. However, any other arrangements make SiC-embedded dummy diffusion regions 32 appear around the SiC device 100 may also be used.

Referring to FIG. 3, to effectively counteract the micro-loading effect of SiC growth, a dummy SiC layer 32a is grown in each of the SiC-embedded dummy diffusion regions 32. The dummy SiC layer 32a is grown concurrently with the SiC stressor layers 102a and 103a. As best seen in FIG. 3, the dummy poly-Si patterns 34 are situated directly above the STI 14 and do not overlap with the SiC-embedded dummy diffusion regions 32.

As shown in FIG. 2 and FIG. 3, the plurality of SiC-embedded dummy diffusion regions 32 and the plurality of dummy poly-Si patterns 34 are disposed within a middle annular region 300. The middle annular region 300 is between an inner region 200 and an outer region 400, wherein the SiC device 100 is disposed within the inner region 200.

A plurality of dummy poly-Si patterns 34 and a plurality of SiC-free dummy diffusion regions 36 are provided in the outer region 400. The term "SiC-free" refers to not containing SiC herein. No SiC is grown in the SiC-free dummy diffusion regions 36. Likewise, the dummy poly-Si patterns 34 and the SiC-free dummy diffusion regions 36 are arranged, but not limited to, in an alternate manner. Each dummy poly-Si pattern 34 is formed on the STI 14. Analogously, the dummy poly-Si pattern 34 does not overlap with the SiC-free dummy diffusion region 36 in the outer region 400.

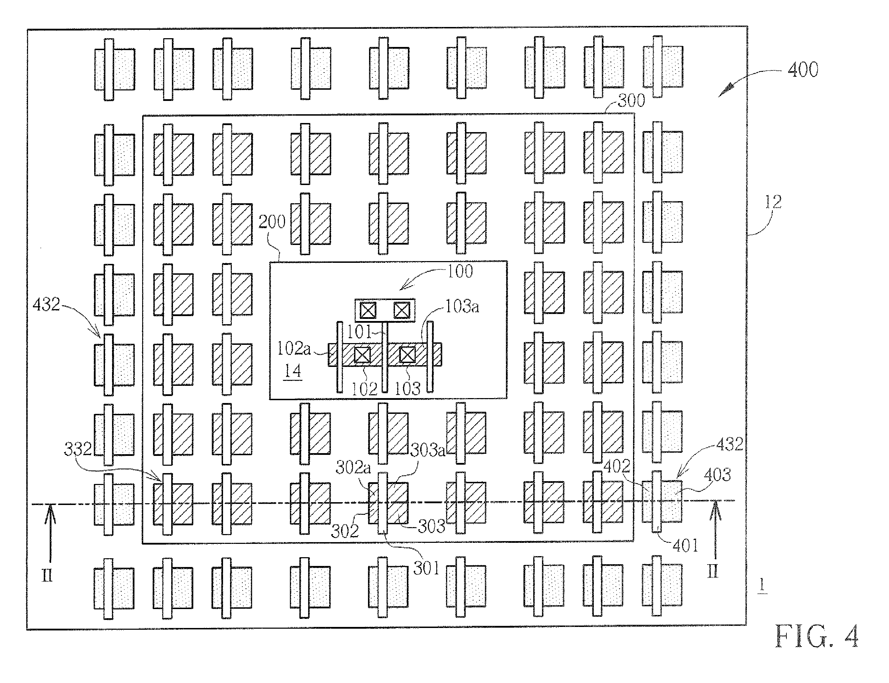

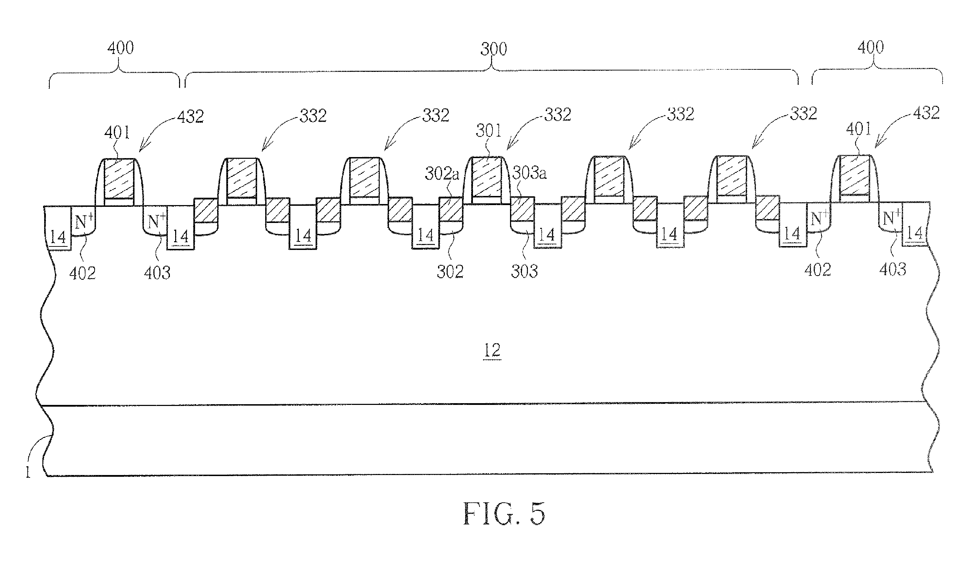

Please refer to FIG. 4 and FIG. 5. FIG. 4 is a schematic top view showing the layout of the SiC device and SiC-embedded dummy pattern in accordance with the third preferred embodiment of this invention, and FIG. 5 is a schematic, cross-sectional diagram taken along line II-II of FIG. 4. As shown in FIG. 4, a SiC device 100 is formed in a P well 12 of a substrate 1. The substrate 1 may be a silicon substrate, SOI substrate or other suitable semiconductor substrates. According to the third preferred embodiment, the SiC device 100 may include but not limited to an NMOS transistor and comprises a gate stack 101, a N⁺ source diffusion region 102, an N⁺ drain diffusion region 103, and an N channel between the N⁺ source diffusion region 102 and the N⁺ drain diffusion region 103. SiC stressor layers 102a and 103a are formed on the N⁺ source diffusion region 102 and the N⁺ drain diffusion region 103, respectively. STI 14 is formed in the substrate 1 to electrically isolate the SiC device 100.

According to the third preferred embodiment, a plurality of SiC-embedded, cell-like dummy patterns 332 are disposed within the middle annular region 300, which is between the inner region 200 and the outer region 400. The SiC device 100 is disposed within the inner region 200. A plurality of SiC-free, cell-like dummy patterns 432 are disposed within the outer region 400.

In this embodiment, the SiC-embedded, cell-like dummy patterns 332 are fabricated concurrently with the SiC device 100. Therefore, each of the SiC-embedded, cell-like dummy patterns 332 may have the same structure as that of the SiC device 100 except that no contact is formed on the SiC-embedded, cell-like dummy patterns 332. That is, each of the SiC-embedded, cell-like dummy patterns 332 has a dummy gate 301, a dummy N⁺ diffusion region 302 and a dummy N⁺ diffusion region 303. SiC layers 302a and 303a are formed on the dummy N⁺ diffusion region 302 and the dummy N⁺ diffusion region 303, respectively.

Each of the SiC-free, cell-like dummy patterns 432 disposed within the outer region 400 may have the same structure as that of the SiC device 100 except the contact and the SiC layer. As best seen in FIG. 5, each of the SiC-free, cell-like dummy patterns 432 has a dummy gate 401, a dummy N⁺ diffusion region 402 and a dummy N⁺ diffusion region 403. No SiC layers are formed on the dummy N⁺ diffusion region 402 and the dummy N⁺ diffusion region 403.

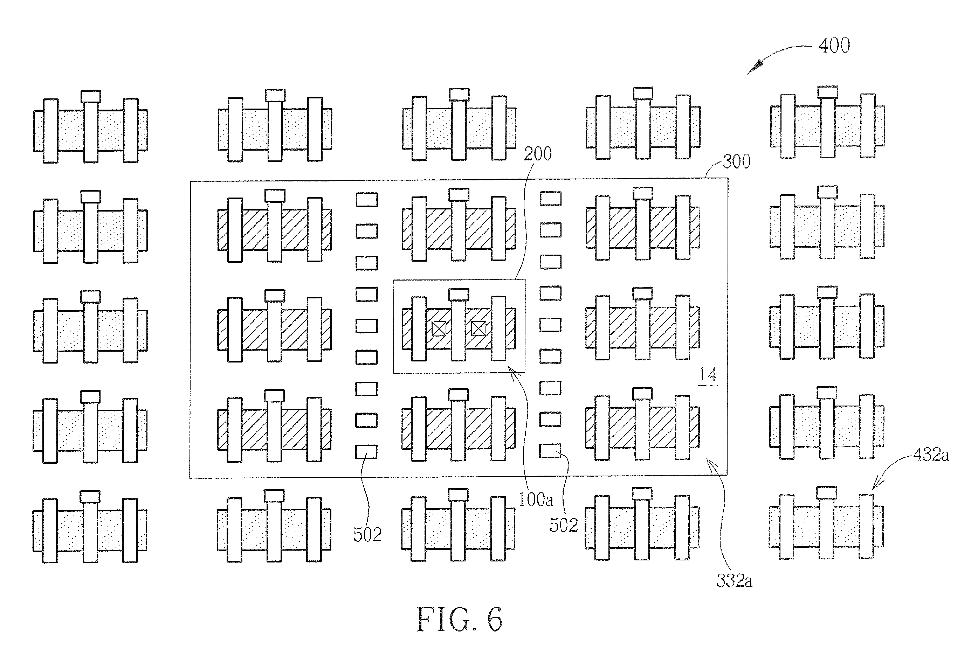

FIG. 6 is a schematic top view showing the layout of the SiC device and SiC-embedded dummy pattern in accordance with the fourth preferred embodiment of this invention. As shown in FIG. 6, a SiC device 100a is formed in an inner region 200. A plurality of SiC-embedded, cell-like dummy patterns 332a are formed in the middle annular region 300 that surrounds the inner region 200. A plurality of SiC-free, cell-like dummy patterns 432a are formed in the outer region 400.

The SiC-embedded, cell-like dummy patterns 332a may be fabricated concurrently with the SiC device 100a. Therefore, each of the SiC-embedded, cell-like dummy patterns 332a may have the same structure as that of the SiC device 100a except that no contact is formed on the SiC-embedded, cell-like dummy patterns 332a. Each of the SiC-free, cell-like dummy patterns 432a disposed within the outer region 400 may have the same structure as that of the SiC device 100a except the contact and the SiC layer.

One germane feature of the fourth preferred embodiment as set forth in FIG. 6 is that a plurality of poly-Si dummy patterns 502 are added in the middle annular region 300. In this embodiment, these poly-Si dummy patterns 502 are disposed on the STI 14 and situated between the SiC-embedded, cell-like dummy patterns 332a. By adding these poly-Si dummy patterns 502, the poly-Si critical dimension (CD) can be improved.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A semiconductor device with dummy patterns, comprising:
a semiconductor substrate having thereon a middle annular region between an inner region and an outer region;
a SiC device on the semiconductor substrate within the inner region;
a plurality of first dummy patterns provided on the semiconductor substrate within the middle annular region, wherein at least one of the first dummy patterns contains SiC; and
a plurality of second dummy patterns provided on the semiconductor within the outer region, wherein the second dummy patterns do not contain SiC.

2. A semiconductor device with dummy patterns, comprising:
a semiconductor substrate having thereon a middle annular region between an inner region and an outer region;
a SiC device on the semiconductor substrate within the inner region; and
a plurality of first dummy patterns provided on the semiconductor substrate within the middle annular region, wherein at least one of the first dummy patterns contains SiC;
wherein the plurality of first dummy patterns comprise dummy poly silicon patterns and SiC-embedded dummy diffusion regions, and wherein the dummy poly silicon patterns and the SiC-embedded dummy diffusion regions are arranged in an alternate manner within the middle annular region.

3. The semiconductor device with dummy patterns according to claim 2, wherein the dummy poly silicon pattern does not overlap with the SiC-embedded dummy diffusion region.

4. A semiconductor device with dummy patterns, comprising:
a semiconductor substrate having thereon a middle annular region between an inner region and an outer region;
a SiC device on the semiconductor substrate within the inner region; and
a plurality of first dummy patterns provided on the semiconductor substrate within the middle annular region, wherein at least one of the first dummy patterns contains SiC;
wherein the SiC device is an N-channel metal-oxide-semiconductor (NMOS) transistor.

5. A semiconductor device with dummy patterns, comprising:
a semiconductor substrate having thereon a middle annular region between an inner region and an outer region;
a SiC device on the semiconductor substrate within the inner region; and
a plurality of first dummy patterns provided on the semiconductor substrate within the middle annular region, wherein at least one of the first dummy patterns contains SiC;
wherein the SiC device functions as a circuit component of mixed-signal circuits, RF circuits or analog circuits.

6. A semiconductor device, comprising:
a semiconductor substrate having thereon a middle annular region between an inner region and an outer region;
a SiC device on the semiconductor substrate within the inner region;
a plurality of SiC-embedded, cell-like dummy patterns provided on the semiconductor substrate within the middle annular region, wherein each of the SiC-embedded, cell-like dummy patterns has substantially the same structure as that of the SiC device; and
a plurality of SiC-free, cell-like dummy patterns in the outer region.

7. The semiconductor device according to claim 6, wherein the SiC device is electrically isolated by shallow trench isolation (STI).

8. The semiconductor device according to claim 6, wherein the SiC device is an N-channel metal-oxide-semiconductor (NMOS) transistor.

9. The semiconductor device according to claim 8, wherein the SiC device comprises a gate stack, an N+ source diffusion region, an N+ drain diffusion region, and an N channel between the N+ source diffusion region and the N+ drain diffusion region.

10. The semiconductor device according to claim 9, wherein a SiC stressor layer is formed on the N+ source diffusion region and the N+ drain diffusion region.

11. The semiconductor device according to claim 6, wherein each of the SiC-embedded, cell-like dummy pattern comprises a dummy gate, a dummy N+ diffusion region and a dummy N+ diffusion region, and wherein a SiC layer is formed on the dummy N+ diffusion region and the dummy N+ diffusion region.

12. The semiconductor device according to claim 6, wherein the SiC device functions as a circuit component of mixed-signal circuits, RF circuits or analog circuits.

13. The semiconductor device according to claim 6, wherein the semiconductor substrate comprises a silicon substrate.
